# EUROPEAN PATENT APPLICATION

(11) **EP 2 251 909 A2**
(43) Date of publication of application: **17.11.2010**
(21) Application number: 10162004.5
(22) Date of filing: 05.05.2010
(51) Int. Cl.: H01L 31/04, H01L 31/0224, H01L 31/18, H01L 31/0336, H01L 27/142, H01L 31/0392, H01L 31/05

(54) **Solar cell structure and manufacturing method thereof**

(30) Priority: 13.05.2009 TW 098115931
(71) Applicant: AxunTek Solar Energy Co., Ltd., Chinese Taipei (TW)
(72) Inventor: Chen, Yen-Chun, Luzhu Shiang KH 821 Chinese Taipei (TW)
(74) Representative: Viering, Jentschura & Partner

(57) **Abstract**

The present invention provides a solar cell structure and the manufacturing method thereof, The solar cell structure includes an active layer (24) having a plurality of first recesses (27') near the edges thereof; and a transparent conductive layer (26) forming on the active layer (24) and having a plurality of second recesses (25') near the edges thereof connecting to the plurality of first recesses (27').

## Description

The invention is related to a structure and a manufacturing method for a solar cell, and more particularly to a structure and a manufacturing method increasing effective areas for a solar cell.

Solar cell is a photovoltaic device that is capable to directly convert the light energy into purely electric energy. The most commonly-seen material for making the solar cell is silicon (Si) which has a single crystal or a polycrystal structure. However, the cost of power generation for a silicon-based solar cell is far more expensive than that for other conventional power generating methods, such as hydroelectric power generation and thermal power generation. Therefore, the efforts to cut off the cost of power generation for a solar cell are started in early 1970s. One of the feasible schemes to reduce the power generation cost for solar cell is to develop a thin film growth technology with low cost which tries to deposit light absorbing materials on a large-scale substrate and at the same time to manufacture the solar cell by the method having high yield but low cost.

The excellent absorbing material for thin film solar cell is semiconductor material consisting of elements in Group IB (Cu, Ag and Au), Group IIIA(B, Al, Ga, In and Tl), Group VIA (O, S, Se, Te and Po) or Group IBIIIAVIA (chalcopyrites) of the Periodic Table of Elements. Particularly, the compound, CIGS, Cu(In, Ga)(S, Se)₂ or CuIn₁₋ₓGa₁₋ₓ(S_{y}Se_{1-y})ₖ, wherein the values of x and y are ranged between 0 to 1 and the value of k is about 2, made of elements Cu, In, Ga, S and Se have been utilized to manufacture the solar cell with a conversion efficiency about 20%. It is demonstrated a high possibility to utilize the material including elements Al in group IIIA and Te in group VIA as an absorber. Therefore, the research and development to the material as being an absorber layer for the solar cell are highly focused and interested on compounds including one of the following elements: (1) Cu in group IB; (2) one of elements In, Ga and Al in group IIIA; and (3) one of elements S, Se and Te in group VIA.

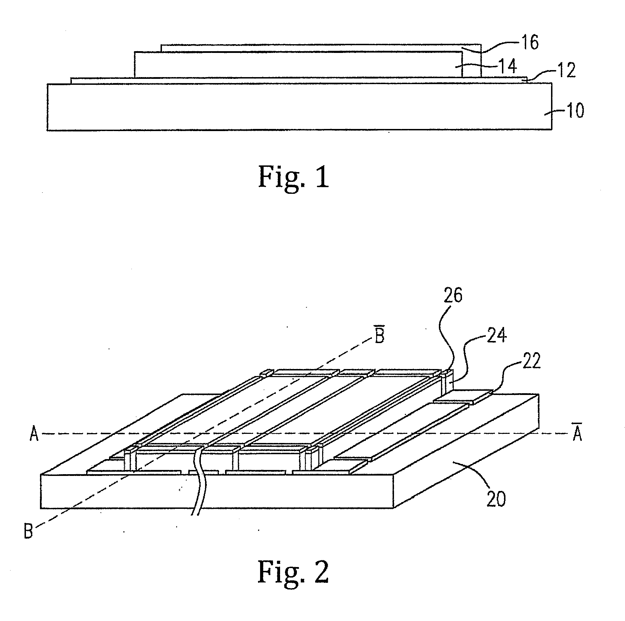

Fig. 1 is a diagram illustrating the structure for a conventional thin film solar cell consisting of a plurality of photovoltaic cells having a compound including elements in Group IBIIIAVIA such as Cu(In, Ga, Al)(S, Se, Te)₂. The photovoltaic cell structure 1 is formed on a substrate 10, e.g. a soda-lime glass, a flexible metal foil like stainless steel foil, a copper foil and an aluminum alloy foil, or some polymers like polyimide. The light absorption layer 14 having elements Cu(In, Ga, Al)(S, Se, Te)₂ is deposited on the conductive layer 12, wherein the conductive layer 12 is pre-deposited on the substrate 10 so as to be a contact point for electrically connecting to the photovoltaic cell structure 1. The conductive layer 12 in Fig. 1 can be made by various elements Mo, Ta, W, Ti, Cu, Al or stainless steel optionally. If the substrate 10 is appropriately made from a conductive material, the conductive layer 12 would not be unnecessary and could be omitted, because the substrate 10 is an ohmic contact point for electrically connecting to the device. After the light absorption layer 14 is grow, a transparent layer 16 consisting of depositions, such as CdS, ZnO, or CdS/ZnO, is consequently formed thereon. Radiation enters in the photovoltaic cell structure 1 through the transparent layer 16. The light absorption layer 14 is preferably a p-type semiconductor and the transparent layer 16 is preferably an n-type semiconductor and vice versa. That is the light absorption layer 14 is an n-type semiconductor and the transparent layer 16 is a p-type semiconductor.

However, there are some defects existing in the above-mentioned conventional device and process for manufacturing the same. For instance, an alignment deviation resulted from manufacturing process will lead to a short circuit. The size of the elements formed at both left and right ends of the photovoltaic cell structure 1 may differ from other normal ones which are resulted from a deviated alignment of the transparent layer 14, whereby the electric property of the elements must be correspondingly influenced. Moreover, an effective size for work area of a solar cell is often diminished from 4 mm to 8 mm due to the shadow effect caused by the alignment deviation from a machine.

In order to solve the alignment issue in the forgoing background of the invention, a structure and a manufacturing method for a solar cell is provided in the present invention for preventing an alignment deviation and increasing the conversion efficiency of some components of the solar cell, so as to upgrade the entire conversion efficiency for the solar cell.

The present invention aims to provide a structure of the thin film solar cell without alignment deviation issue.

The present invention also aims to provide a method manufacturing a thin film solar cell having a larger effective area.

In accordance with the first aspect of the present invention, a solar cell structure is provided. A solar cell structure, including an active layer having a plurality of first recesses near the edges thereof; and a transparent conductive layer forming on the active layer and having a plurality of second recesses near the edges thereof connecting to the plurality of first recesses.

Preferably, the structure further includes a substrate; and a conductive layer forming on the substrate having a plurality of third recesses and forth recesses vertical to each other.

Preferably, the active layer has a plurality of fifth recesses and a plurality of sixth recesses perpendicular to the plurality of third recesses and the transparent conductive layer has a plurality of seventh recesses connecting to the plurality of sixth recesses.

Preferably, the conductive layer has a material being one selected from a group consisting of Mo, Ta, W, Ti, Al, stainless steel and a combination thereof.

Preferably, the active layer is a light absorption layer.

Preferably, the light absorption layer has a material being a Group IBIIIAVIA compound.

Preferably, the structure of the Group IBIIIAVIA compound is Chalcopyrites.

Preferably, the element of Group IB is Cu, the element of Group IIIA is one selected from a group consisting of In, Ga and a combination thereof, and the element of Group VIA is one selected from a group consisting of Se, S and a combination thereof.

Preferably, the structure further includes a buffer layer having a material being one selected from a group consisting of CdS, InS, InSe, ZnS, ZnMgO and a combination thereof.

In accordance with the second aspect of the present invention, a solar cell structure is provided. A solar cell structure, including an active layer having a first recess therearound; and a transparent conductive layer forming on the active layer and having a second recess connecting to the first recess.

Preferably, the structure further includes a substrate; and a conductive layer forming between the substrate and the active layer and having a plurality of third recesses and forth recesses vertical to each other.

Preferably, the active layer has a plurality of fifth recesses and a plurality of sixth recesses perpendicular to the plurality of third recesses and the transparent conductive layer has a plurality of seventh recesses connecting to the plurality of sixth recesses.

In accordance with the third aspect of the present invention, a solar cell structure is provided. A manufacturing method of solar cell structure, including steps of (A) providing an active layer; (B) forming a transparent conductive layer on the active layer; and (C) removing partially the active layer and the transparent conductive layer to respectively form a plurality of first recesses and second recesses near the edge thereof.

Preferably, the method further includes steps of (A01) providing a substrate; (A02) forming a conductive layer between the substrate and the active layer; and (A03) removing partially the conductive layer to form a plurality third recesses and the plurality of forth recesses vertical to each other.

Preferably, the conductive layer and the transparent conductive layer are formed by sputtering technique and the third recesses and the forth recesses are formed by laser scribing technique.

Preferably, the method further includes steps of (Bl) removing partially the active layer to form a plurality of fifth recesses perpendicular to the plurality of third recesses.

Preferably, the method further includes steps of (C1) removing partially the transparence conductive layer and the active layer to respectively form a plurality of sixth recesses and seventh recesses connecting to each other.

Preferably, the first recesses, the second recesses, the fifth recesses, the sixth recesses and the seventh recesses are formed by mechanical scribing technique.

Preferably, the first recesses are connected to the second recesses and the sixth recesses are connected to the seventh recesses.

Preferably, the active layer is formed by one selected from a group consisting of a co-evaporation technique, a sputtering selenization technique, a coating process technique, a chemical spray pyrolysis technique, an electrodeposition technique and a combination thereof.

Other objects, advantages and efficacy of the present invention will be described in detail below taken from the preferred embodiments with reference to the accompanying drawings, in which:

Fig. 1 is a diagram illustrating the structure for a conventional thin film solar cell;

Fig. 2 is a diagram illustrating a structure for the solar cell according to the present invention;

Fig. 3A and 3B are sectional diagrams illustrating a preferred embodiment of the present invention;

Fig. 4A and 4B are sectional diagrams illustrating a preferred embodiment of the present invention; and

Fig. 5A and 5B are sectional diagrams illustrating a preferred embodiment of the present invention.

The present invention will now be described more specifically to the following embodiments. However, it is to be noted that the following descriptions of preferred embodiments of this invention are presented herein for the purposes of illustration and description only; it is not intended to be exhaustive or to be limited to the precise form disclosed.

Moreover, in order to provide clearer descriptions to facilitate easily understanding of the present invention, the parts of the drawing do not draw in accordance with their relative sizes. Some sizes and scales have been exaggerated. The parts of unrelated details are not drawn completely to simplify the drawing.

Fig. 2 is a diagram illustrating a structure for the solar cell according to the present invention. A substrate 20 acting as an under layer is preferably made of material selected from a group consisting of glass, flexible metal foil like stainless steel foil, copper foil and aluminum alloy foil, some polymer like polyimide (PI) and a combination thereof. A conductive layer 22 preferably made of material selected from a group consisting of Mo, Ta, W, Ti, Cu, Al, stainless steel, transparent conductive material and a combination thereof, for facilitating the conduction of holes, is formed on the substrate 20 by sputtering and has a thickness ranged between 0.5∼1.0µm. An active layer 24 acting as a light absorption layer preferably made of Cu(In, Ga, Al)(S, Se, Te)₂ is formed on the conductive layer 22 and has a thickness ranged between 1.5∼2.0µm. An n-type semiconductor buffer layer preferably made of material selected from a group consisting of CdS, InS, InSe, ZnS, ZnMgO and a combination thereof, for helping the effective conduction of the electron, is formed on the active layer 24 and has a thickness of 0.05µm. A pure n-type semiconductor ZnO layer is optionally formed on the buffer layer and has a thickness of 0.1 µm. The ZnO layer prevents the thin film solar cell from the shunting issue that would decrease the conversion efficiency during power generation process. The ZnO layer is optional and is not absolutely necessary. A transparent conductive layer 26 acting as an upper electrode is formed on the ZnO layer by sputtering and is made of material selected from a group consisting of transparent conductive oxide, like NiO/Au, Indium Tin Oxide (ITO), ZnO, AlZnO and a combination thereof. Light passes through the transparent conductive layer 26 to reach the active layer 24. A structure for thin film solar cell CIGS is accordingly disclosed as aforementioned and could be manufactured by a corresponding process.

Currently, there are many coating methods utilized for forming a thin film of the light absorption layer 24, for instance, a vacuum process including a co-evaporation and a sputtering selenization and a non-vacuum process including a coating process, a chemical spray pyrolysis and an electrodeposition.

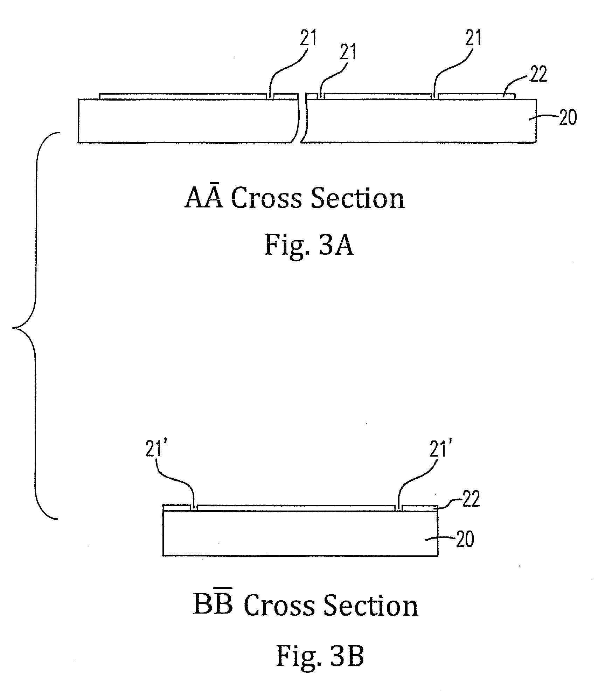

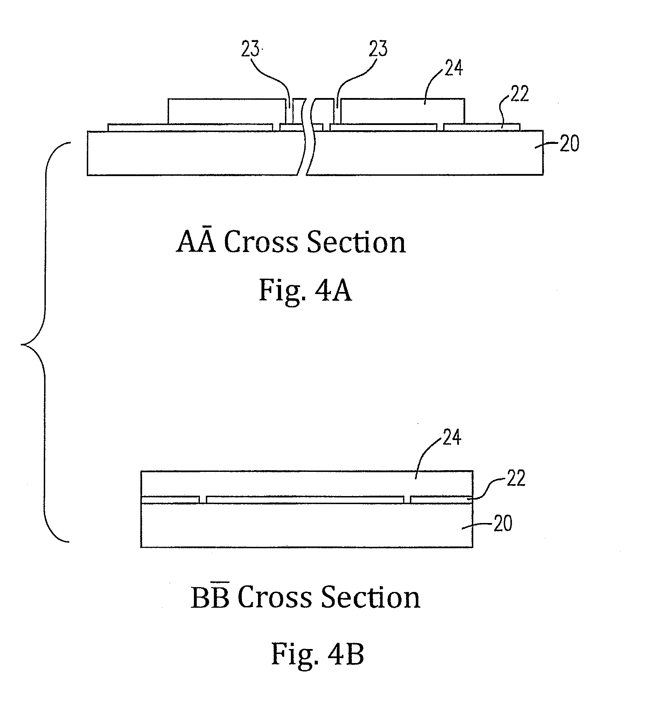

Figs. 3-5 are sectional diagrams illustrating a preferred embodiment for the structure of a thin film solar cell according to the present invention. First, a substrate 20 having a material like lime-soda glass is provided as shown in Fig. 3. A conductive layer 20 is then formed on the substrate 20 and is partially removed to form a plurality of third recesses 21 vertical to the substrate 20 on the AA̅ cross section referring to Fig. 2 as shown in Fig. 3A and to form a plurality of forth recesses 21' perpendicular to the plurality of third recesses 21 on the BB̅ cross section as shown in Fig. 3B by a laser scribing scheme, so as to form and insulate a plurality of the thin film solar cells. Then, an active layer 24 is formed on the conductive layer 22 and is then partially removed to form a plurality of fifth recesses 23 vertical to the substrate 20 on the AA̅ cross section as shown in Fig. 4A by a mechanical scribing scheme, so as to form a connecting window for being used by the conductive layer 22 for electrically connecting.

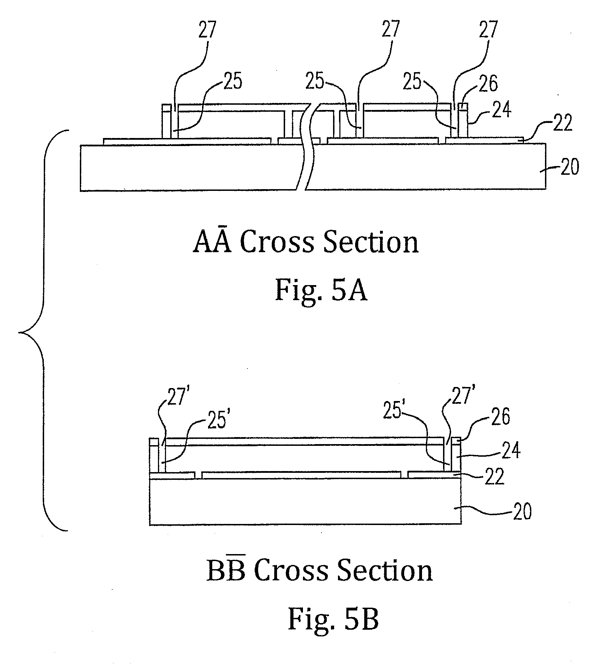

A transparent conductive layer 26 is furthermore formed on the active layer 24. The active layer 24 and the transparent conductive layer 26 are partially removed to form a plurality of sixth recesses 27 and seventh recesses 25 vertical to the substrate 20 on the AA̅ cross section as shown in Fig. 5A and to form a plurality of first recesses 27' and second recesses 25' perpendicular to the plurality of sixth recesses 27 and seventh recesses 25 near the edges of the active layer 24 and the transparent conductive layer 26 on the BB̅ cross section as shown in Fig. 5B, so that an effective area of solar cell is accurately defined by the plurality of first recesses 27' and second recesses 25'. Since the plurality of first recesses 27' and second recesses 25' are formed near the edges of the transparent conductive layer 26 and divide the transparent conductive layer 26 into a effective part and an unnecessary part, which clearly defines the effective area for the transparent conductive layer 26, the alignment deviation resulted from the shadow effect during the process for forming the transparent conductive layer 26 would be accordingly avoided. The preferred embodiment of the present invention can accurately define the effective area for a thin film solar cell, prevent the shadow effect and increase the effective area of a solar cell.

## Claims

1. A solar cell structure, **characterized by** comprising:
an active layer (24) having a plurality of first recesses (27') near the edges thereof; and
a transparent conductive layer (26) forming over the active layer (24) and having a plurality of second recesses (25') near the edges thereof connecting to the plurality of first recesses (27').

2. The solar cell structure as claimed in Claim 1, **characterized by** comprising:
a substrate (20); and
a conductive layer (22) forming on the substrate (20) having a plurality of third recesses (21) and forth recesses (21') vertical to each other.

3. The solar cell structure as claimed in Claim 2, **characterized in that** the active layer (24) has a plurality of fifth recesses (23) and a plurality of sixth recesses (27) perpendicular to the plurality of third recesses (21) and the transparent conductive layer (26) has a plurality of seventh recesses (25) connecting to the plurality of sixth recesses (27).

4. The solar cell structure as claimed in Claim 1, **characterized in that** the conductive layer (22) has a material being one selected from a group consisting of Mo, Ta, W, Ti, Al, stainless steel and a combination thereof.

5. The solar cell structure as claimed in Claim 1, **characterized in that** the active layer (24) is a light absorption layer having a material being a Group IBIIIAVIA compound and the structure of the Group IBIIIAVIA compound is Chalcopyrites.

6. The solar cell structure as claimed in Claim 5, **characterized in that** the element of Group IB is Cu, the element of Group IIIA is one selected from a group consisting of In, Ga and a combination thereof, and the element of Group VIA is one selected from a group consisting of Se, S and a combination thereof.

7. The solar cell structure as claimed in Claim 1, **characterized by** comprising a buffer layer having a material being one selected from a group consisting of CdS, InS, InSe, ZnS, ZnMgO and a combination thereof.

8. A manufacturing method of solar cell structure, **characterized by** comprising steps of:
(A) providing an active layer (24);
(B) forming a transparent conductive layer (26) on the active layer (24); and
(C) removing partially the active layer (24) and the transparent conductive layer (26) to respectively form a plurality of first recesses (27') and second recesses (25') near the edge thereof.

9. The method as claimed in Claim 8, **characterized by** comprising steps of:
(A1) providing a substrate (20);
(A2) forming a conductive layer (22) between the substrate (20) and the active layer (24); and
(A3) removing partially the conductive layer (22) to form a plurality third recesses (21) and the plurality of forth recesses (21') vertical to each other.

10. The method as claimed in Claim 9, **characterized in that** the conductive layer (22) and the transparent conductive layer (26) are
formed by sputtering technique and the third recesses (21) and the forth recesses (21') are formed by laser scribing technique.

11. The method as claimed in Claim 9, **characterized by** comprising steps of: (B1) removing partially the active layer (24) to form a plurality of fifth recesses (23) perpendicular to the plurality of third recesses (21).

12. The method as claimed in Claim 11, **characterized by** comprising steps of: (C1) removing partially the transparence conductive layer (26) and the active layer (24) to respectively form a plurality of sixth recesses (27) and seventh recesses (25) connecting to each other.

13. The method as claimed in Claim 12, **characterized in that** the first recesses (27'), the second recesses (25'), the fifth recesses (23), the sixth recesses (27) and the seventh recesses (25) are formed by mechanical scribing technique.

14. The method as claimed in Claim 13, **characterized in that** the first recesses (27') are connected to the second recesses (25') and the sixth recesses (27) are connected to the seventh recesses (25).

15. The method as claimed in Claim 8, **characterized in that** the active layer (24) is formed by one selected from a group consisting of a co-evaporation technique, a sputtering selenization technique, a coating process technique, a chemical spray pyrolysis technique, an electrodeposition technique and a combination thereof.
